(19) Europäisches Patentamt European Patent Office Office européen des brevets

(11) **EP 4 082 106 B1**

(12) **EUROPEAN PATENT SPECIFICATION**

(45) Date of publication and mention of the grant of the patent:
**05.02.2025 Bulletin 2025/06**

(21) Application number: **19829623.8**

(22) Date of filing: **23.12.2019**

(51) International Patent Classification (IPC):
*H02M 1/12* (2006.01)       *H02M 7/5387* (2007.01)
*G01R 31/00* (2006.01)

(52) Cooperative Patent Classification (CPC):
**H02M 1/12; H02M 7/53875;** G01R 31/008

(86) International application number:
**PCT/EP2019/086904**

(87) International publication number:
**WO 2021/129921 (01.07.2021 Gazette 2021/26)**

(54) **METHOD AND DEVICE FOR CONTROLLING A STATIC FREQUENCY CONVERTER FOR RAILWAY APPLICATIONS**

VERFAHREN UND VORRICHTUNG ZUR STEUERUNG EINES STATISCHEN FREQUENZUMRICHTERS FÜR EISENBAHNANWENDUNGEN

PROCÉDÉ ET DISPOSITIF DE COMMANDE D'UN CONVERTISSEUR DE FRÉQUENCE STATIQUE POUR APPLICATIONS FERROVIAIRES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**02.11.2022 Bulletin 2022/44**

(73) Proprietor: **Hitachi Energy Ltd**
**8050 Zürich (CH)**

(72) Inventors:
• **BANCEANU, Cosmin**
**5630 Muri (CH)**
• **BAERLOCHER, Eugen**
**5300 Turgi (CH)**
• **LUCANO, Luigi**
**79761 Waldshut (DE)**

(74) Representative: **AWA Sweden AB**
**Box 45086**
**104 30 Stockholm (SE)**

(56) References cited:
• **DIRIK HASAN ET AL: "New extraction method for active, reactive and individual harmonic components from distorted current signal", IET GENERATION, TRANSMISSION&DISTRIBUTION, IET, UK, vol. 8, no. 11, 1 November 2014 (2014-11-01), pages 1767 - 1777, XP006049866, ISSN: 1751-8687, DOI: 10.1049/IET-GTD.2013.0500**
• **TECHNICAL COMMITTEE CLC/SC 9XC - ELECTRIC SUPPLY AND EARTHING SYSTEMS FOR PUBLIC TRANSPORT EQUIPMENT AND ANCILLARY APPARATUS: "prEN 50388-2:2017 Railway Applications - Fixed installations and rolling stock - Technical criteria for the coordination between power supply and rolling stock to achieve interoperability - Part 2: stability and harmonics", 30 April 2017 (2017-04-30), XP055725845, Retrieved from the Internet <URL:https://standards.iteh. ai/catalog/standards/clc/f5fb00d6-1f29-4dd4-a8f d-e3e478907499/pren-50388-2-2017> [retrieved on 20200908]**

- **ANONYMOUS: "In-phase and quadrature components - Wikipedia", 30 October 2019 (2019-10-30), XP055728876, Retrieved from the Internet <URL:https://en.wikipedia.org/w/index.php?title=In-phase_and_quadrature_components&oldid=923884749> [retrieved on 20200908]**

- **ANONYMOUS: "In-phase and quadrature components - Wikipedia", 30 October 2019 (2019-10-30), XP055728876, Retrieved from the Internet <URL:https://en.wikipedia.org/w/index.php?title=In-phase_and_quadrature_components&oldid=923884749> [retrieved on 20200908]**

**Description**

**TECHNICAL FIELD**

The present disclosure relates to the field of electric railway traction. In particular, it relates to a device for controlling a static frequency converter (SFC) suitable for facilitating electric measurements on a connected railway grid and on rolling stock powered by the railway grid.

**BACKGROUND**

For railway systems with frequencies like 16.7 Hz, 25 Hz or 50 Hz, static frequency converters (SFCs) are already a well-established power supply solution. However, besides power flow control, in the future the SFCs could offer the capability to identify faulty behaviour of the rolling stock or various characteristics of the grid.

Satisfactory coordination between the rolling stock, railway grid and further fixed installations is an important interoperability factor in contemporary railway systems. New vehicles are typically fitted with highly sophisticated and sensitive electric circuitry, including many active components and control loops, and it is therefore crucial for designers to understand their interaction with the grid and ensure compatibility. Poor tuning may lead to instabilities that manifest themselves in the line voltage and current and ultimately to degraded performance. The new vehicles furthermore must undergo rigorous testing before they are released for commercial operation. As one example, the European norm EN 50388-2 (*Railway Applications - Fixed installations and rolling stock - Technical criteria for the coordination between power supply and rolling stock to achieve interoperability-Part 2: Stability and harmonics*) specifies tests for evaluating electric resonance stability, low-frequency power oscillations and robustness to overvoltage caused by harmonics. Another example is the international norm IEC 62310.

Testing according to the current proposal prEN 50388-2:2017 (draft version, CENELEC, September 2017) includes subjecting the tested equipment to a test signal of the form specified in equation A.1 therein, namely:

$$U(t) = U_{d0} \cos \omega_N t - U_{q0} \sin \omega_N t + U_{da} \cos \omega_N t \cos \omega_T t - U_{db} \cos \omega_N t \sin \omega_T t - U_{qa} \sin \omega_N t \cos \omega_T t + U_{qb} \sin \omega_N t \sin \omega_T t,$$

where $\omega_N$ is a constant fundamental (angular) frequency of the network, $\omega_T$ is a variable test (angular) frequency, and the six amplitudes $U_{d0}$, $U_{q0}$, $U_{da}$, $U_{db}$, $U_{qa}$, $U_{qb}$ are real-valued functions of time. The test frequency $\omega_T$ is varied, in one or more frequency sweeps, to allow recording of a frequency response. The highly nonlinear test signal $U(t)$ shall be generated with testing-grade accuracy, yet with an ability to withstand heavy loading, e.g., when supplying one or more locomotives having a rated power of several megawatts each.

State-of-the-art SFCs fail to adequately address the task of supplying a test signal with the above characteristics.

**SUMMARY**

One objective of the invention is to propose devices for supplying a non-linear test signal to a railway grid. It is a particular objective to propose such devices that enable testing in accordance with EN 50388-2.

These and other objective are achieved by the invention as defined by the independent claim. The dependent claims provide embodiments of the invention.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. For conciseness of this presentation, an angular frequency may be referred to simply as a frequency when no confusion can arise.

**BRIEF DESCRIPTION OF THE DRAWINGS**

Aspects and embodiments are now described, by way of example, with reference to the accompanying drawings, on which:

> figure 1 shows a testing environment;
> figure 2 is a simplified electric model of the testing environment shown in figure 1;
> figure 3 shows a control architecture of an SFC;
> figure 4 shows a controller for supplying the composite control signal, suitable for the control architecture of an SFC according to figure 3; and

figure 5 is a flowchart of a method describing automatic control of a phase and amplitude of an SFC.

**DETAILED DESCRIPTION**

The aspects of the invention will now be described more fully with reference to the accompanying drawings, on which certain embodiments of the invention are shown.

These aspects may, however, be embodied in many different forms and should not be construed as limiting; rather, the embodiments are provided by way of example so that this disclosure will be thorough and complete, and to fully convey the scope of all aspects of invention to those skilled in the art. Like numbers refer to like elements throughout the description.

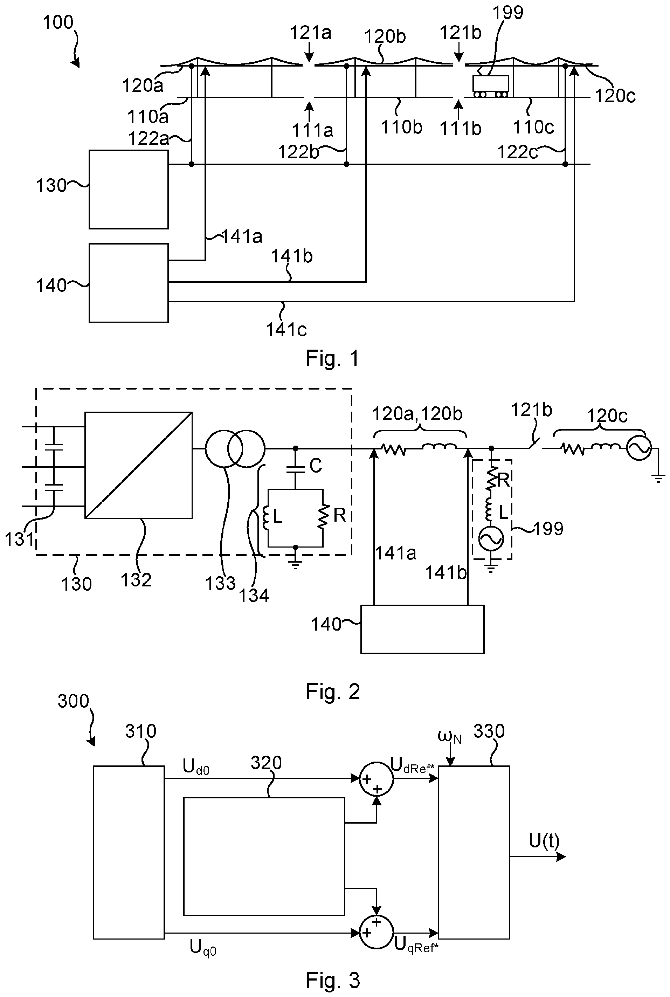

Figure 1 shows an environment 100 suitable for performing electric measurements on rolling stock, exemplified by a railway vehicle 199 electrically powered by a section 120c of a railway grid. The railway grid, which may be implemented as an overhead line or a third rail, comprises further sections 120a, 120b which are each connected, via supply lines 122a, 122b, 122c, to an SFC 130. The sectioning of the railway grid may be achieved by switches or isolators 121, which define the endpoints of the sections 120. The sectioning of the railway grid may correspond to or overlap with track blocks 110a, 110b, 110c of a railway track on which the vehicle 199 runs. The environment 100 further comprises measuring equipment 140, 141a, 141b, 141c allowing electric measurements to be performed at different points of the railway grid 120 independently. Preferably, each railway grid section 120 is provided with one or more sensors 141a, 141b, 141c, such as high-accuracy sensors. The measurements may, as suggested by figure 1, be available at a central node 140, to allow comparisons or detection of variations between different locations of the railway grid 120 or to examine spatial patterns.

Optionally, the environment comprises signalling equipment (not shown) for monitoring and/or controlling rolling stock. The signalling equipment is no essential component of the environment 100 unless the measurements or tests to be performed relate to the coordination with the signalling equipment.

The set-up of the test environment 100 can be used for various rolling stock tests.

Example 1: Tests of rolling stock's protection, wherein the SFC can control voltage/current amplitude/frequency.

Example 2: Tests of rolling stock's continuous operation capability at different grid frequency. The SFC can control the nominal frequency of the sectioned/island grid to analyse not only the frequency supervision protection functions on board the trains but also the control loop behaviour when the grid frequency deviates. It is therefore easy for the rail operator to check whether the rolling stock is satisfactorily operable in the whole requested frequency range.

Example 3: Measurements of the rolling stock's harmonic spectrum. The SFC can generate low to high frequency sweeps (up to the SFC's modulator limits) in order to check it. The rolling stock has its own harmonic current spectrum based on the way the pulsing is realized for the on-board semiconductors. Therefore, the vehicle design (transformers, modulator technique, filters) must be carefully tested by the rail operator with reference to the given limits defined in norms and standards.

Example 4: Measurements of the rail grid's impedance. Information about the grid impedance can be used for various purposes. For example, one of them is the minimization of overvoltage risk in the grid caused by resonances. The electrical rail power supply system (including transformers, catenary, cables, filters, etc.) contains resonance points, which can be in the range of several hundred Hertz. If such resonance frequencies coincide with the switching frequency of rolling stock's on-board semiconductors, the resonances can be excited and lead to overvoltage.

Example 5: Low-frequency stability tests for rolling stocks as defined in EN 50388-2 standard.

Example 6: Tests of track circuits and signalling systems. The objective in this case would be to check the quality of various devices that can be found usually along the rail track. For example, it may be assessed whether a low frequency or transient interference in the grid will falsely operate a track relay. Such set-up will allow the rail grid operator to determine the maximum permissible levels in the track. These levels can be correlated later with the rolling stock performance.

Apparently, the test environment 100 is suitable not only for the tests defined in EN 50388-2 standard but also for different types of tests. In the latter cases, the SFC 130 may have a state-of-the-art control architecture.

Moreover, it is expected that low-frequency oscillations (subharmonic oscillations) occur not only when the rolling stock is running but also when standing still with the control loops active. Considering this, testing may be performed not only on moving rolling stock but also stationary rolling stock. During a test, one or more moving vehicle may be present in the testing environment 100, optionally in combination with one or more stationary vehicles that draw idling or standby power from the grid.

Figure 2 is a simplified electric model of a testing environment of the type shown in figure 1. The first and second railway grid sections 120a, 120b are modelled as serially arranged resistances R and inductances L. The last railway grid section 120c is modelled as a resistance R, inductance L and alternating-current (AC) source connecting to ground. The vehicle 199 is modelled as an AC source drawing current from a section of the railway grid through a series of resistance R and inductance L to ground. Obviously, the vehicle 199 can move between the railway sections and may therefore experience different impedance at different times.

Figure 2 shows example inner workings of the SFC 130. The SFC 130 is powered by direct-current (DC) capacitors 131, which may be connected to a utility grid or a different power source. The DC capacitors 131 connect via a DC-to-AC converter 132, which is preferably bidirectional to allow regenerative braking, to a transformer 133. An RLC-type high-pass filter 134 tuned to draining unwanted highfrequency components to ground is arranged at the output of the SFC 130.

It is emphasized that figure 2 shows an example implementation of the SFC 130. This implementation as well as the railway grid 120 and vehicle 199 have additionally undergone abstraction and idealization to arrive at a useful mathematical model that is computationally efficient and furthers understanding.

Figure 3 shows a control architecture 300 of the SFC 130, which comprises a first controller 310, which is configured to provide a fundamental control signal $U_0(t) = [U_{d0}(t)\ U_{q0}(t)]^T$ for controlling a phase and amplitude of a carrier waveform at a fundamental frequency $\omega_N$ of the railway grid. For example, the fundamental frequency may be $2\pi \cdot 16.7$ Hz, $2\pi \cdot 25$ Hz or $2\pi \cdot 50$ Hz. The components of $U_0$ may not be in a one-to-one relationship with the phase and amplitude, but rather correspond to a modulation with orthogonal components {cos $\omega_N t$, - sin $\omega_N t$}; see also figure A.3 of EN 50388-2.

The control architecture 300 further comprises a second controller 320, which is configured to generate a first modulating signal $U_d(t) = [U_{d\alpha}(t)\ U_{d\beta}(t)]^T$ and a second modulating signal $U_q(t) = [U_{q\alpha}(t)\ U_{q\beta}(t)]^T$ as seen in a synchronous reference frame rotating at a modulation frequency $\omega_T$. The second controller is further configured to provide a representation, or at least a partial representation, of the first and second modulating signals in a stationary reference frame. The reference frame may be understood as stationary in the sense that the oscillation at the modulation frequency $\omega_T$ is no longer concealed; as further discussed below. The modulation frequency $\omega_T$ may be different from the fundamental frequency $\omega_N$. For tests of low-frequency oscillation, the modulation frequency $\omega_T$ is usually lower or significantly lower than the fundamental frequency $\omega_N$. For other tests or measurements, the opposite relation may hold.

In the control architecture 300, the first components of the representations of the first and second modulating signals $U_d$, $U_q$ in the stationary reference frame are summed with a respective first and second component of the fundamental control signal $U_0$ to obtain a composite control signal $U_{Ref^*}(t) = [U_{dRef^*}(t)\ U_{qRef^*}(t)]^T$. A modulator 330 is controlled by the composite control signal and an indication of the fundamental frequency $\omega_N$, so as to provide an output $U(t)$ of the SFC 130 accordingly. The output $U(t)$ is preferably a loadable signal that may be fed to the railway grid. In other words, the modulator 330 shall have high internal resistance.

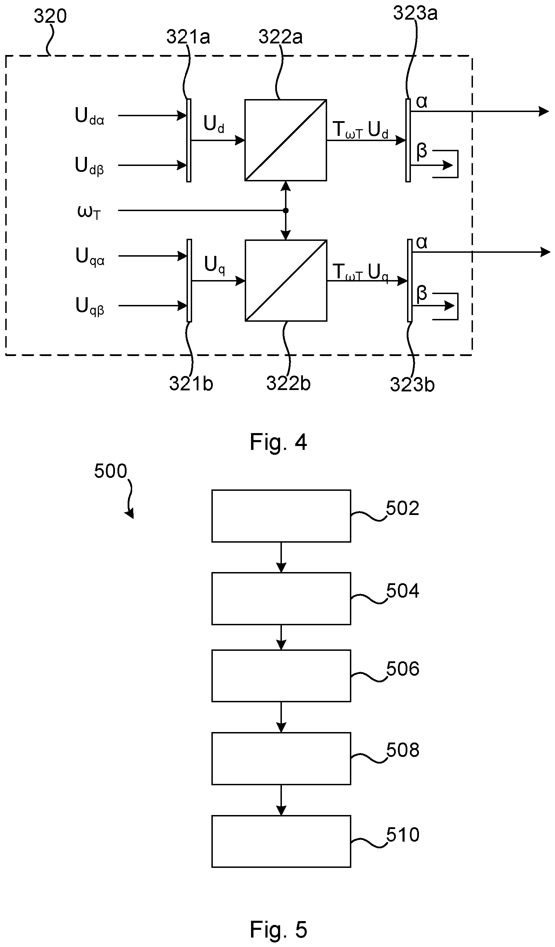

Figure 4 shows an example structure of the second controller 320. A first composition element 321a receives the components $U_{d\alpha}(t)$, $U_{d\beta}(t)$ of the first modulating signal $U_d$ in a synchronous reference frame rotating at $\omega_T$. This is to say, the oscillation at frequency $\omega_T$ is implicit from the representation. The first composition element 321a forms the first modulating signal $U_d$ and supplies it to a first dq-to-$\alpha\beta$ converter 322a. The first dq-to-$\alpha\beta$ converter 322a transforms the first modulating signal $U_d$ into a stationary reference frame, which renders explicit the oscillation at frequency $\omega_T$ which was hitherto absorbed in the basis vectors. The dq-to-$\alpha\beta$ transformation is given by

$$\begin{cases} u_\alpha = u_d \cos \omega_T t - u_q \sin \omega_T t \\ u_\beta = u_d \cos \omega_T t + u_q \sin \omega_T t \end{cases},$$

and corresponds, with $\omega = \omega_T$, to the action of the matrix

$$T_\omega = \begin{bmatrix} \cos \omega t & -\sin \omega t \\ \cos \omega t & \sin \omega t \end{bmatrix}.$$

Alternatively, the first dq-to-$\alpha\beta$ converter 322a may be regarded as a modulator configured to a generate an output signal that is a linear combination of {cos $\omega_T t$, - sin $\omega_T t$} as weighted by the components of the first modulating signal $U_d$.

A first decomposition element 323a downstream of the first dq-to-$\alpha\beta$ converter 322a receives the components of the transformed first modulating signal $U_d$ and extracts the first component ($\alpha$ component), which forms one of the outputs of the second controller 320. It is not necessary for the first dq-to-$\alpha\beta$ converter 322a to provide the second component ($\beta$ component) which is not used here. Accordingly, it suffices to generate the transformed first modulating signal as

$$\left(T_{\omega_T} U_d\right)(t) = \begin{bmatrix} U_{d\alpha}(t) \cos \omega_T t - U_{d\beta}(t) \sin \omega_T t \\ * \end{bmatrix}$$

where * denotes an arbitrary or absent element. It is recalled that the time dependence of the amplitudes $U_{d\alpha}(t)$, $U_{d\beta}(t)$ corresponds to the modulation over time. By an analogous processing chain, comprising a second composition element 321b, second dq-to-$\alpha\beta$ converter 322b and second decomposition element 323b, a transformed second modulating signal is obtained:

$$\left(T_{\omega_T} U_q\right)(t) = \begin{bmatrix} U_{q\alpha}(t) \cos \omega_T t - U_{q\beta}(t) \sin \omega_T t \\ * \end{bmatrix}.$$

The first and second dq-to-αβ converters 322a, 322b may be implemented in software executed by a general-purpose computer, as application-specific integrated circuits (ASICs), field-programmable gate arrays (FPGAs) or as a non-programmable chip or chipset. The first and second dq-to-αβ converters 322a, 322b may be general-purpose circuitry that is not dedicated to the specific signalling processing tasks occurring in an SFC 130.

Returning to figure 3, the composite control signal $U_{Ref*}$ obtained by the summations is given by

$$U_{Ref*}(t) = \begin{bmatrix} U_{dRef*}(t) \\ U_{qRef*}(t) \end{bmatrix} = \begin{bmatrix} U_{d0}(t) + U_{d\alpha}(t) \cos \omega_T t - U_{d\beta}(t) \sin \omega_T t \\ U_{q0}(t) + U_{q\alpha}(t) \cos \omega_T t - U_{q\beta}(t) \sin \omega_T t \end{bmatrix}.$$

The composite control signal $U_{Ref*}$ controls the action of the modulator 330, which forms a linear combination of components $\{\cos \omega_N t, -\sin \omega_N t\}$. This yields, in a stationary reference frame,

$$U(t) = (U_{d0}(t) + U_{d\alpha}(t)\cos\omega_T t - U_{d\beta}(t) \sin \omega_T t) \cos \omega_N t + (U_{q0}(t) + U_{q\alpha}(t)\cos\omega_T t - U_{q\beta}(t) \sin \omega_T t) \sin\omega_N t.$$

An SFC output of this form is equal to the signal required by equation A.1 of EN 50388-2.

Alternatively, the output of the modulator 330 may be considered as the first component (α component) of a dq-to-αβ transformation $T_\omega$ applied to $U_{Ref*}$ with $\omega = \omega_N$.

Figure 5 is flowchart of a method 500. The method facilitates automatic control of a phase and amplitude of an SFC. It comprises a first step 502 of obtaining a fundamental control signal $[U_{d0}\ U_{q0}]^T$ for controlling a phase and amplitude of a carrier waveform at a fundamental frequency $\omega_N$. In a second step 504 of the method, a representation is obtained in a synchronous reference frame rotating at a modulation frequency $\omega_T$, of a first modulating signal $[U_{d\alpha}\ U_{d\beta}]^T$ and a second modulating signal $[U_{q\alpha}\ U_{q\beta}]^T$. In a third step 506, each of the first and second modulating signals is transformed into a stationary reference frame. In a fourth step 508, there is provided a representation, in a synchronous reference frame rotating at the fundamental frequency, of a composite control signal for controlling the phase and amplitude of said output of the SFC. In the composite reference signal, a first component is a sum of a first component of the fundamental control signal and a first component of the transformed first modulating signal, and a second component is a sum of a second component of the fundamental control signal and a first component of the transformed second modulating signal. In an optional fifth step 510, the composite control signal is transformed into a stationary reference frame, whereby the oscillation at frequency $\omega_N$ is rendered explicit.

The method 500 may be implemented as instructions in a computer program. When the program is executed by a computer controlling an SFC, the SFC carries out the method 500.

## Claims

1. A static frequency converter, SFC, comprising:

a first controller (310) configured to provide a fundamental control signal ($U_0(t) = [U_{d0}\ U_{q0}]^T$) for controlling a phase and amplitude of a carrier waveform at a fundamental frequency ($\omega_N$) wherein the components of the fundamental control signal ($U_0$) correspond to a modulation with orthogonal components $\{\cos \omega_N t, -\sin \omega_N t\}$;

a second controller (320), which is configured to:

obtain a representation, in a synchronous reference frame rotating at a modulation frequency ($\omega_T$), of a first modulating signal ($U_d(t) = [U_{d\alpha}\ U_{d\beta}]^T$) and a second modulating signal ($U_q(t) = [U_{q\alpha}\ U_{q\beta}]^T$);

transform each of the first and second modulating signals into a stationary reference frame; and

provide a representation, in a synchronous reference frame rotating at the fundamental frequency ($\omega_N$), of a composite control signal $U_{Ref*}(t) = [U_{dRef*}\ U_{qRef*}]^T$ for controlling the phase and amplitude of an output of the SFC, wherein:

a first component of the composite control signal is a sum of a first component of the fundamental control signal and a first component of the transformed first modulating signal:

$$U_{dRef*} = U_{d0}(t) + U_{d\alpha}(t) \cos \omega_T t - U_{d\beta}(t) \sin \omega_T t;$$

and

a second component of the composite control signal is a sum of a second component of the fundamental control signal and a first component of the transformed second modulating signal:

$$U_{qRef*} = U_{q0}(t) + U_{q\alpha}(t) \cos \omega_T t - U_{q\beta}(t) \sin \omega_T t,$$

the SFC further comprising a modulator (330) configured to receive the composite control signal and to provide, based thereon, said output of the SFC:

$U(t) = U_{d0}(t) \cos \omega_N t - U_{q0}(t) \sin \omega_N t + U_{d\alpha}(t) \cos \omega_N t \cos \omega_T t - U_{d\beta}(t) \cos \omega_N t \sin \omega_T t - U_{q\alpha}(t) \sin \omega_N t \cos \omega_T t + U_{q\beta}(t) \sin \omega_N t \sin \omega_T t,$

wherein the SFC is configured to feed a railway grid (120) for electrically powering rolling stock (199), and, the SFC is configured to be used in a testing environment (100) comprising measuring equipment (140, 141a, 141b, 141c) configured to perform electric measurements at different points of the railway grid (120) independently, and to detect variation between different locations of the railway grid (120).

2.  The SFC of claim 1, wherein the fundamental frequency ($\omega_N$) and the modulation frequency ($\omega_T$) are different.

3.  The SFC of any of the preceding claims, wherein each of said transformations of a signal $[u_\alpha \ u_\beta]^T$ represented in a synchronous reference frame at rotation frequency $\omega$ into stationary reference frame corresponds to the action of a matrix $T_\omega$ given as

$$T_\omega = \begin{bmatrix} \cos \omega t & -\sin \omega t \\ \cos \omega t & \sin \omega t \end{bmatrix}.$$

4.  The SFC any of the preceding claims, wherein the output of the SFC is a loadable signal.

5.  The SFC any of the preceding claims, wherein the first and second modulating signals represent, respectively, amplitude and phase modulation of the output of the SFC.

6.  A testing environment (100), comprising:

a railway track (110);
optional signalling equipment for monitoring and/or controlling rolling stock (199) running on the railway track;
a railway grid (120) for electrically powering the rolling stock;
an electric sensor (140) connected to the railway grid or a section thereof; and
the SFC of any of the preceding claims arranged to feed the railway grid.

**Patentansprüche**

1.  Statischer Frequenzumrichter (SFC), der Folgendes umfasst:

einen ersten Controller (310), der ausgebildet ist, um ein Grundsteuersignal ($U_0(t) = [U_{d0} \ U_{q0}]^T$) zum Steuern einer Phase und Amplitude einer Trägerwellenform bei einer Grundfrequenz ($\omega_N$) bereitzustellen, wobei die Komponenten des Grundsteuersignals ($U_0$) einer Modulation mit orthogonalen Komponenten {cos $\omega_N t$, -sin $\omega_N t$} entsprechen;
einen zweiten Controller (320), der für Folgendes ausgebildet ist:

Erhalten einer Repräsentation, in einem synchronen Referenzrahmen, der sich mit einer Modulationsfrequenz ($\omega_T$) dreht, eines ersten Modulationssignals ($U_d(t) = [U_{d\alpha} \ U_{d\beta}]^T$) und eines zweiten Modulationssignals ($U_q(t) = [U_{q\alpha} \ U_{q\beta}]^T$);
Transformieren sowohl des ersten als auch des zweiten Modulationssignals in einen stationären Referenzrahmen; und

Bereitstellen einer Repräsentation, in einem synchronen Referenzrahmen, der sich mit der Grundfrequenz ($\omega_N$) dreht, eines zusammengesetzten Steuersignals $U_{\text{Ref}*}(t) = [\, U_{dRef*}\ Uq_{Ref*}]^T$ zum Steuern der Phase und Amplitude eines Ausgangs des SFC, wobei:

eine erste Komponente des zusammengesetzten Steuersignals eine Summe aus einer ersten Komponente des Grundsteuersignals und einer ersten Komponente des transformierten ersten Modulationssignals ist:

$$U_{dRef*} = U_{d0}(t) + U_{d\alpha}(t)\cos\omega_T t - U_{d\beta}(t)\sin\omega_T t\,;$$

und

eine zweite Komponente des zusammengesetzten Steuersignals eine Summe aus einer zweiten Komponente des grundlegenden Steuersignals und einer ersten Komponente des transformierten zweiten Modulationssignals ist:

$$U_{qRef*} = U_{q0}(t) + U_{q\alpha}(t)\cos\omega_T t - U_{q\beta}(t)\sin\omega_T t,$$

wobei der SFC ferner einen Modulator (330) umfasst, der ausgebildet ist, das zusammengesetzte Steuersignal zu empfangen und darauf basierend das Ausgangssignal des SFC bereitzustellen:

$U(t) = U_{d0}(t)\cos\omega_N t - U_{q0}(t)\sin\omega_N t + U_{d\alpha}(t)\cos\omega_N t\cos\omega_T t - U_{d\beta}(t)\cos\omega_N t\sin\omega_T t - U_{q\alpha}(t)\sin\omega_N t\cos\omega_T t + U_{q\beta}(t)\sin\omega_N t\sin\omega_T t,$

wobei der SFC dafür ausgebildet ist, ein Eisenbahnnetz (120) für die elektrische Energieversorgung von Rollmaterial (199) zu speisen und,
wobei der SFC so ausgebildet ist, dass er in einer Testumgebung (100) verwendet werden kann, die Messgeräte (140, 141a, 141b, 141c) umfasst, die ausgebildet sind, um elektrische Messungen an verschiedenen Punkten des Eisenbahnnetzes (120) unabhängig durchzuführen, und um Abweichungen zwischen verschiedenen Stellen des Eisenbahnnetzes (120) zu erkennen.

2. SFC nach Anspruch 1, wobei die Grundfrequenz ($\omega_N$) und die Modulationsfrequenz ($\omega_T$) unterschiedlich sind.

3. SFC nach einem der vorhergehenden Ansprüche, wobei jede der Transformationen eines Signals $[u_\alpha\ u_\beta]^T$, das in einem synchronen Referenzrahmen mit der Rotationsfrequenz $\omega$ dargestellt wird, in einen stationären Referenzrahmen der Wirkung einer Matrix $T_\omega$ entspricht, die gegeben ist als

$$T_\omega = \begin{bmatrix} \cos\omega t & -\sin\omega t \\ \cos\omega t & \sin\omega t \end{bmatrix}.$$

4. SFC nach einem der vorhergehenden Ansprüche, wobei der Ausgang des SFC ein ladbares Signal ist.

5. SFC nach einem der vorhergehenden Ansprüche, wobei das erste und das zweite Modulationssignal eine Amplituden- bzw. Phasenmodulation des Ausgangs des SFC darstellen.

6. Testumgebung (100), die Folgendes umfasst:

eine Eisenbahnstrecke (110);
optionale signaltechnische Geräte zur Überwachung und/oder Steuerung des auf der Eisenbahnstrecke fahrenden Rollmaterials (199);
ein Eisenbahnnetz (120) zur elektrischen Energieversorgung des Rollmaterials;
einen elektrischen Sensor (140), der mit dem Eisenbahnnetz oder einem Abschnitt davon verbunden ist; und
den SFC nach einem der vorhergehenden Ansprüche, der zur Einspeisung in das Eisenbahnnetz angeordnet ist.

**Revendications**

1. Convertisseur de fréquence statique, SFC, comprenant :

   un premier contrôleur (310) configuré pour fournir un signal de commande fondamental ($U_0(t) = [U_{d0} \ U_{q0}]^T$) pour contrôler la phase et l'amplitude d'une forme d'onde porteuse à une fréquence fondamentale ($\omega_N$), où les composantes du signal de commande fondamental ($U_0$) correspondent à une modulation avec des composantes orthogonales {cos $\omega_N t$, -sin $\omega_N t$} ;
   un deuxième contrôleur (320), qui est configuré pour :

   obtenir une représentation, dans un référentiel synchrone tournant à une fréquence de modulation ($\omega_T$), d'un premier signal de modulation ($U_d(t) = [U_{d\alpha} \ U_{d\beta}]^T$) et d'un deuxième signal de modulation ($U_q(t) = [U_{q\alpha} \ U_{q\beta}]^T$) ;
   transformer chacun des premier et deuxième signaux de modulation dans un référentiel stationnaire ; et
   fournir une représentation, dans un référentiel synchrone tournant à la fréquence fondamentale ($\omega_N$), d'un signal de commande composite $U_{Ref*}(t) = [U_{dRef*} \ U_{qRef*}]^T$ pour contrôler la phase et l'amplitude d'une sortie du SFC, où :

   une première composante du signal de commande composite est une somme d'une première composante du signal de commande fondamental et d'une première composante du premier signal de modulation transformé :

   $$U_{dRef*} = U_{d0}(t) + U_{d\alpha}(t) \cos \omega_T t - U_{d\beta}(t) \sin \omega_T t \quad ;$$

   et
   une deuxième composante du signal de commande composite est une somme d'une deuxième composante du signal de commande fondamental et d'une première composante du deuxième signal de modulation transformé :

   $$U_{qRef*} = U_{q0}(t) + U_{q\alpha}(t) \cos \omega_T t - U_{q\beta}(t) \sin \omega_T t,$$

   le SFC comprend en outre un modulateur (330) configuré pour recevoir le signal de commande composite et pour fournir, sur la base de celui-ci, ladite sortie du SFC :

   $U(t) = U_{d0}(t) \cos \omega_N t - U_{q0}(t) \sin \omega_N t + U_{d\alpha}(t) \cos \omega_N t \cos \omega_T t - U_{d\beta}(t) \cos \omega_N t \sin \omega_T t - U_{q\alpha}(t) \sin \omega_N t \cos \omega_T t + U_{q\beta}(t) \sin \omega_N t \sin \omega_T t,$

   où le SFC est configuré pour alimenter un réseau ferroviaire (120) afin d'alimenter électriquement le matériel roulant (199), et
   le SFC est configuré pour être utilisé dans un environnement d'essai (100) comprenant un équipement de mesure (140, 141a, 141b, 141c) configuré pour effectuer des mesures électriques en différents points du réseau ferroviaire (120) de manière indépendante, et pour détecter les variations entre différents emplacements du réseau ferroviaire (120).

2. SFC selon la revendication 1, dans lequel la fréquence fondamentale ($\omega_N$) et la fréquence de modulation ($\omega_T$) sont différentes.

3. SFC selon l'une quelconque des revendications précédentes, dans lequel chacune desdites transformations d'un signal $[u_\alpha \ u_\beta]^T$ représenté dans un référentiel synchrone à la fréquence de rotation $\omega$ dans un référentiel stationnaire correspond à l'action d'une matrice $T_\omega$ donnée comme suit

$$T_\omega = \begin{bmatrix} \cos \omega t & -\sin \omega t \\ \cos \omega t & \sin \omega t \end{bmatrix}.$$

4. SFC selon l'une quelconque des revendications précédentes, dans lequel la sortie du SFC est un signal chargeable.

5. SFC selon l'une quelconque des revendications précédentes, dans lequel les premier et deuxième signaux de modulation représentent respectivement une modulation d'amplitude et de phase de la sortie du SFC.

6. Environnement d'essai (100) comprenant :

une voie ferrée (110) ;
un équipement de signalisation optionnel pour surveiller et/ou contrôler le matériel roulant (199) circulant sur la voie ferrée ;
un réseau ferroviaire (120) pour l'alimentation électrique du matériel roulant ;
un capteur électrique (140) connecté au réseau ferroviaire ou à une section de celui-ci ; et
le SFC de l'une quelconque des revendications précédentes agencé pour alimenter le réseau ferroviaire.

EP 4 082 106 B1

Fig. 1

Fig. 2

Fig. 3

Fig. 4

Fig. 5

**EP 4 082 106 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *prEN 50388-2:2017*, September 2017